# EUROPEAN PATENT APPLICATION

(11) **EP 3 876 156 A1**
(43) Date of publication of application: **08.09.2021**
(21) Application number: 19898369.4
(22) Date of filing: 17.07.2019
(51) Int. Cl.: G06K 19/077, H04B 1/3816

(54) **MEMORY CARD, CONNECTOR, AND RECOGNITION METHOD FOR FUNCTIONAL CARD**

(30) Priority: 20.12.2018 CN 201811565683
(71) Applicant: Huawei Technologies Co., Ltd., Longgang District Shenzhen, Guangdong 518129 (CN)
(72) Inventor: DENG, Enhua, Shenzhen, Guangdong 518057 (CN); GUO, Dan, Shenzhen, Guangdong 518057 (CN); PANG, Weiwen, Shenzhen, Guangdong 518057 (CN); LI, Zhixiong, Shenzhen, Guangdong 518057 (CN)
(74) Representative: Pfenning, Meinig & Partner mbB
(86) International application number: PCT/CN2019/096439
(87) International publication number: WO 2020/125003

(57) **Abstract**

A memory card, a connector, and a functional card identification method are provided. The memory card (10) includes a packaging board (11); and a plurality of contacts disposed on one side surface of the packaging board (11). The plurality of contacts include a power supply contact (12a), a grounding contact (12b), and a detection contact (12c or 12d). The detection contact (12c or 12d) is disposed adjacent to one of the power supply contact (12a) and the grounding contact (12b), and is suspended or electrically connected to the other of the power supply contact (12a) and the grounding contact (12b). In the foregoing manner, the memory card can be identified.

## Description

### TECHNICAL FIELD

This application relates to the field of memory card technologies, and in particular, to a memory card, a connector, and a functional card identification method.

### BACKGROUND

To meet more requirements of a user, an electronic device currently supports use of more functional cards. For example, for a mobile device that supports two cards, two card accommodation slots are disposed on a card tray of the mobile device, to accommodate both the two cards. For example, dual card dual standby may be implemented by using two SIM cards or one SIM card and one memory card.

However, when sharing is implemented between the SIM card and the memory card, how the electronic device accurately identifies a card type becomes a problem that needs to be urgently resolved.

### SUMMARY

To resolve the foregoing problem, this application provides a memory card, a connector, and a functional card identification method, to accurately and quickly identify the memory card.

A technical solution used in this application is as follows: A memory card is provided, and the memory card includes a packaging board; and a plurality of contacts disposed on one side surface of the packaging board. The plurality of contacts include a power supply contact, a grounding contact, and a detection contact. The detection contact is disposed adjacent to one of the power supply contact and the grounding contact, and is suspended or electrically connected to the other of the power supply contact and the grounding contact.

The detection contact includes a first detection contact and a second detection contact. The first detection contact is disposed adjacent to the grounding contact, and is suspended or electrically connected to the power supply contact. The second detection contact is disposed adjacent to the power supply contact, and is suspended or electrically connected to the grounding contact.

The plurality of contacts further include a functional contact. The detection contact is disposed adjacent to the power supply contact, and is suspended or electrically connected to the grounding contact, and the functional contact is disposed adjacent to the grounding contact. Alternatively, the detection contact is disposed adjacent to the grounding contact, and is suspended or electrically connected to the power supply contact, and the functional contact is disposed adjacent to the power supply contact.

An outline dimension of the packaging board matches an outline dimension of a SIM card, to share a same connector with the SIM card. When the SIM card and the memory card overlap, the detection contact on the memory card and the power supply contact or the grounding contact disposed adjacent to the detection contact are at least partially located in a projection area of a power supply contact or a grounding contact corresponding to the SIM card.

The plurality of contacts of the memory card further include a data contact that is at least partially located in the projection area.

The power supply contact or the grounding contact disposed adjacent to the detection contact is disposed at an interval from the data contact in a width direction of the memory card, and the detection contact is disposed at an interval from the power supply contact or the grounding contact disposed adjacent to the detection contact and the data contact in a length direction of the memory card, and is located outside the data contact, and the power supply contact or the grounding contact disposed adjacent to the detection contact.

The plurality of contacts of the memory card further include a first data contact, a command contact, a clock contact, and a second data contact.

The plurality of contacts are distributed in a matrix with four rows and two columns.

Another technical solution used in this application is as follows: A connector is provided, and the connector includes a plurality of contact terminals. The plurality of contact terminals include a power supply terminal, a grounding terminal, and a detection terminal. When a memory card described above is in contact with the connector through fitting, the detection terminal and the power supply terminal or the grounding terminal are respectively in contact with a detection contact on the memory card and a power supply contact or a grounding contact disposed adjacent to the detection contact.

The connector is further shared by a SIM card. When the SIM card is in contact with the connector through fitting, both the detection terminal and the power supply terminal or the grounding terminal are in contact with a power supply contact or a grounding contact corresponding to the SIM card.

There are a plurality of detection terminals, and the plurality of detection terminals correspond to detection contact settings of a plurality of different types of functional cards, to identify different types of functional cards based on detection statuses of different detection terminals.

Another technical solution used in this application is as follows: A functional card identification method is provided, a connector described above is used in the method, and the method includes: powering on a to-be-identified memory card by using a power supply terminal of the connector; determining whether the detection terminal of the connector detects an electrical signal; and identifying the functional card as a memory card or a SIM card based on a detection status of the detection terminal.

The step of identifying the functional card as a memory card or a SIM card based on a detection status of the detection terminal includes: if the detection terminal detects no electrical signal, identifying the functional card as a target memory card; or if the detection terminal detects an electrical signal, further determining whether the electrical signal detected by the detection terminal is the same as an electrical signal detected by a terminal that is disposed adjacent to the detection terminal and that is one of a power supply terminal and a grounding terminal of the connector; and if the electrical signal detected by the detection terminal is the same as the electrical signal detected by the terminal that is disposed adjacent to the detection terminal and that is one of the power supply terminal and the grounding terminal of the connector, identifying the functional card as a SIM card; or if the electrical signal detected by the detection terminal is different from the electrical signal detected by the terminal that is disposed adjacent to the detection terminal and that is one of the power supply terminal and the grounding terminal of the connector, identifying the functional card as a target memory card.

The memory card provided in this application includes the packaging board; and the plurality of contacts disposed on one side surface of the packaging board. The plurality of contacts include the power supply contact, the grounding contact, and the detection contact. The detection contact is disposed adjacent to one of the power supply contact and the grounding contact, and is suspended or electrically connected to the other of the power supply contact and the grounding contact. In the foregoing manner, a detection contact can be added specifically to identify the memory card. In this way, a potential risk of system failure caused by instability in a manner of identifying the memory card by sending an instruction by using software in the prior art is avoided, and the memory card can be quickly identified.

### BRIEF DESCRIPTION OF DRAWINGS

To describe the technical solutions in the embodiments of this application more clearly, the following briefly describes the accompanying drawings for describing the embodiments. Apparently, the accompanying drawings in the following description show merely some embodiments of this application, and a person of ordinary skill in the art may still derive other drawings from these accompanying drawings without creative efforts.
FIG. 1 is a schematic structural diagram of a first embodiment of a memory card according to this application;
FIG. 2 is a schematic structural diagram of a second embodiment of a memory card according to this application;
FIG. 3 is a schematic structural diagram of a SIM card in the prior art;
FIG. 4 is a schematic structural diagram of an NM card;
FIG. 5 is a schematic structural diagram of a third embodiment of a memory card according to this application;
FIG. 6 is a schematic structural diagram of a fourth embodiment of a memory card according to this application;
FIG. 7 is a schematic structural diagram of a fifth embodiment of a memory card according to this application;
FIG. 8 is a schematic diagram of a three-dimensional structure of an embodiment of a connector according to this application;
FIG. 9 is a schematic structural diagram of a front view of an embodiment of a connector according to this application;
FIG. 10 is a schematic flowchart of a first embodiment of a functional card identification method according to this application; and
FIG. 11 is a schematic flowchart of a second embodiment of a functional card identification method according to this application.

### DESCRIPTION OF EMBODIMENTS

In this specification, "embodiment" means that a particular characteristic, structure, or feature described with reference to the embodiment may be included in at least one embodiment of this application. The phrase shown in various locations in this specification may not necessarily mean a same embodiment, and is not an independent or optional embodiment exclusive from another embodiment. It is explicitly and implicitly understood by a person skilled in the art that the embodiments described in this specification may be combined with another embodiment.

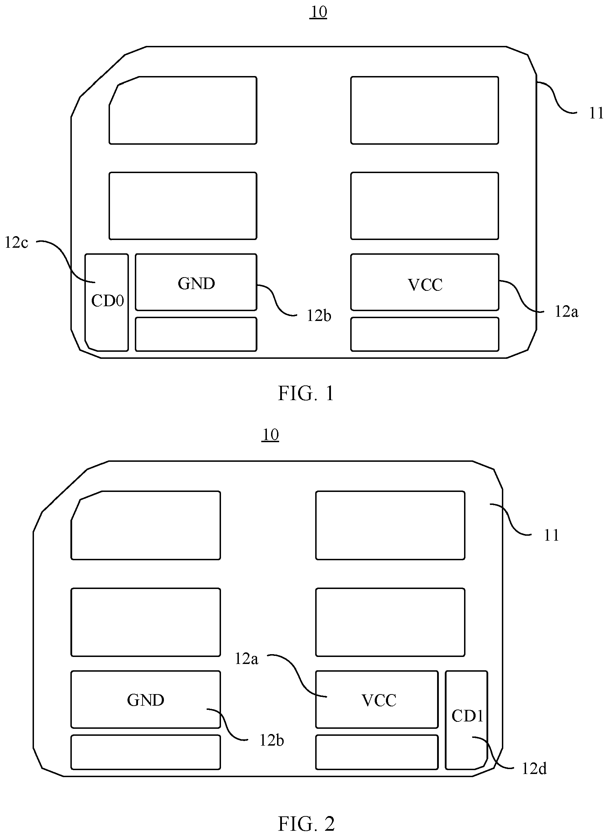

FIG. 1 is a schematic structural diagram of a first embodiment of a memory card according to this application. The memory card 10 includes a packaging board 11 and a plurality of contacts (not shown) disposed on one side surface of the packaging board 11.

The plurality of contacts include a power supply contact 12a, a grounding contact 12b, and a first detection contact 12c. The first detection contact 12c is disposed adjacent to the grounding contact 12b, and is suspended or electrically connected to the power supply contact 12a.

FIG. 2 is a schematic structural diagram of a second embodiment of a memory card according to this application. The memory card 10 includes a packaging board 11 and a plurality of contacts (not shown) disposed on one side surface of the packaging board 11.

The plurality of contacts include a power supply contact 12a, a grounding contact 12b, and a second detection contact 12d. The second detection contact 12d is disposed adjacent to the power supply contact 12a, and is suspended or electrically connected to the grounding contact 12b.

It may be understood that in the foregoing two embodiments, after the memory card 10 is powered on, the power supply contact 12a is at a high potential, the grounding contact 12b is at a low potential, and the detection contact is at a potential different from or opposite to that of an adjacent contact. In this way, the memory card can be easily identified.

Specifically, in the embodiment in FIG. 1, if the first detection contact 12c is coupled to the power supply contact 12a, after the memory card 10 is powered on, the first detection contact 12c is at a high potential, and when it is detected that the first detection contact 12c is at a high potential, the memory card 10 may be identified as a memory card. If the first detection contact 12c is suspended, after the memory card 10 is powered on, if the first detection contact 12c detects no electrical signal, the memory card 10 may be identified as a memory card.

Specifically, in the embodiment in FIG. 2, if the second detection contact 12d is coupled to the grounding contact 12b, after the memory card 10 is powered on, the second detection contact 12d is at a low potential, and when it is detected that the second detection contact 12d is at a low potential, the memory card 10 may be identified as a memory card. If the second detection contact 12d is suspended, after the memory card 10 is powered on, when the second detection contact 12d detects no electrical signal, the memory card 10 may be identified as a memory card.

The following provides a manner of identifying a memory card and a SIM card.

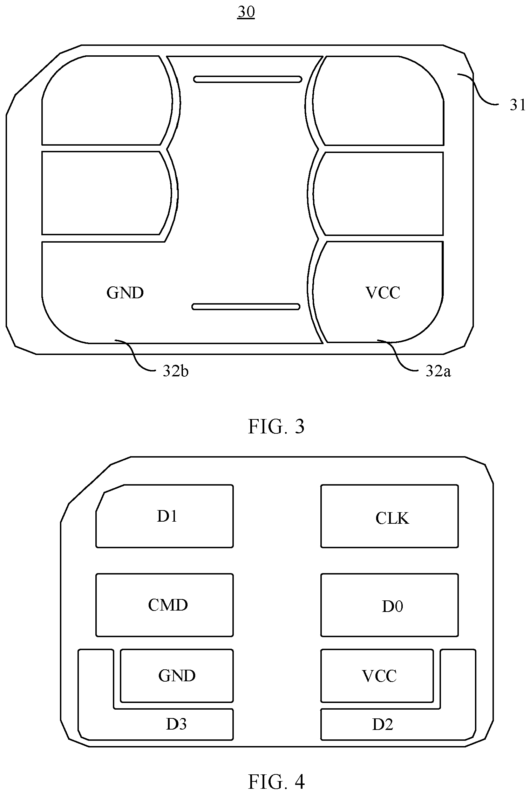

FIG. 3 is a schematic structural diagram of a SIM card in the prior art. The SIM card 30 includes a packaging board 31 and a plurality of contacts (not shown) disposed on one side surface of the packaging board 31. The plurality of contacts include a power supply contact 32a and a grounding contact 32b.

A comparison is made between the schematic structural diagrams in FIG. 1 and FIG. 3. When two contact terminals are used to detect the grounding contact 12b and the first detection contact 12c shown in FIG. 1, potentials detected by the two contact terminals are different, and when the same two contact terminals are used to detect the SIM card 30 shown in FIG. 3, both the two contact terminals are in contact with the grounding contact 32b of the SIM card 30, and potentials detected by the two contact terminals are the same. Therefore, whether a to-be-identified card is the memory card shown in FIG. 1 or the SIM card shown in FIG. 3 may be identified in this manner.

A comparison is made between the schematic structural diagrams in FIG. 2 and FIG. 3. When two contact terminals are used to detect the power supply contact 12a and the second detection contact 12d shown in FIG. 2, potentials detected by the two contact terminals are different, and when the same two contact terminals are used to detect the SIM card 30 shown in FIG. 3, both the two contact terminals are in contact with the power supply contact 32a of the SIM card 30, and potentials detected by the two contact terminals are the same. Therefore, whether a to-be-identified card is the memory card shown in FIG. 2 or the SIM card shown in FIG. 3 may be identified in this manner.

In the foregoing manner, the memory card provided in the embodiments includes the packaging board; and the plurality of contacts disposed on one side surface of the packaging board. The plurality of contacts include the power supply contact, the grounding contact, and the detection contact. The detection contact is disposed adjacent to one of the power supply contact and the grounding contact, and is suspended or electrically connected to the other of the power supply contact and the grounding contact. In the foregoing manner, a detection contact can be added specifically to identify the memory card. In this way, a potential risk of system failure caused by instability in a manner of identifying the memory card by sending an instruction by using software in the prior art is avoided, and the memory card can be quickly identified.

The following describes this application by using an embodiment of an NM card (Nano memory card).

FIG. 4 is a schematic structural diagram of an NM card. The NM card uses an eMMC protocol. An eMMC (Embedded Multi Media Card) is an embedded memory standard specification that is formulated by the MMC association and that is mainly for a product such as a mobile phone or a tablet computer.

The NM card includes eight contacts: a 3.3 V power supply contact (VCC), a grounding contact (GND), a clock contact (CLK), a command contact (CMD), and four data contacts (D0-D3). In this embodiment, the eight contacts are set as follows:

| Sub-contact number | Definition | Sub-contact number | Definition |
|---|---|---|---|
| 1 | D1 | 5 | D2 |
| 2 | CMD | 6 | VCC |
| 3 | GND | 7 | D0 |
| 4 | D3 | 8 | CLK |

The eight contacts are distributed in a matrix with four rows and two columns. Contacts in the first column of the matrix are sequentially a first data contact, the command contact, the grounding contact, and a third data contact, and respectively correspond to a D1 pin, a CMD pin, a GND pin, and a D3 pin in the eMMC protocol. Contacts in the second column of the matrix are sequentially the clock contact, a second data contact, the power supply contact, and a fourth data contact, and respectively correspond to a CLK pin, a D0 pin, a VCC pin, and a D2 pin in the eMMC protocol.

The third data contact (D3) includes an extension portion, and the extension portion extends to an outside of the grounding contact (GND). The fourth data contact (D2) also includes an extension portion, and the extension portion extends to an outside of the power supply contact (VCC).

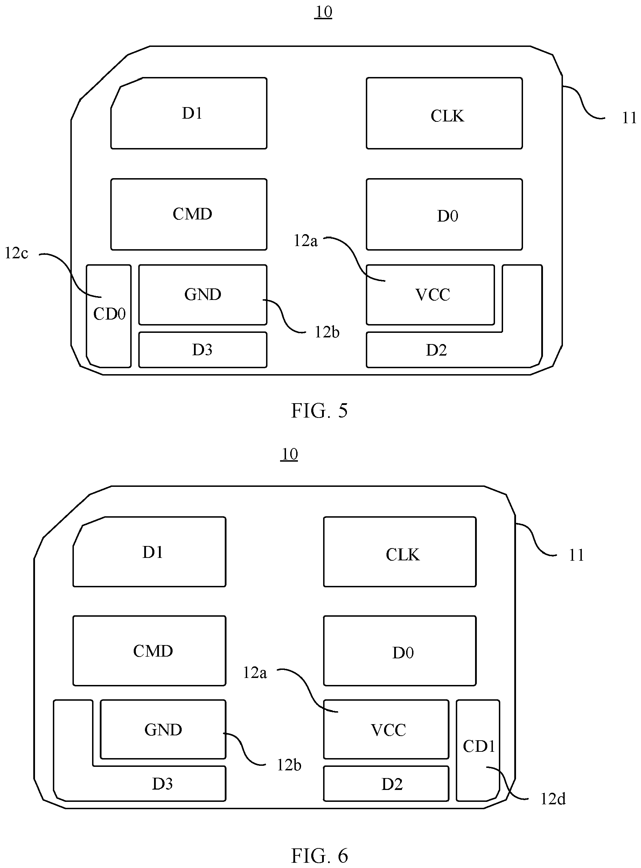

FIG. 5 is a schematic structural diagram of a third embodiment of a memory card according to this application. The memory card 10 in this embodiment includes a packaging board 11 and a plurality of contacts (not shown) disposed on one side surface of the packaging board 11. In this embodiment, the plurality of contacts include nine contacts.

Eight contacts are distributed in a matrix with four rows and two columns. Contacts in the first column of the matrix are sequentially a first data contact, the command contact, the grounding contact, and a third data contact, and respectively correspond to a D1 pin, a CMD pin, a GND pin, and a D3 pin in the eMMC protocol. Contacts in the second column of the matrix are sequentially the clock contact, a second data contact, the power supply contact, and a fourth data contact, and respectively correspond to a CLK pin, a D0 pin, a VCC pin, and a D2 pin in the eMMC protocol.

In addition, a ninth contact is a first detection contact 12c. The grounding contact 12b disposed adjacent to the first detection contact 12c is disposed at an interval from the third data contact (D3) in a width direction of the memory card. The first detection contact 12c is disposed at an interval from the grounding contact 12b disposed adjacent to the first detection contact 12c and the third data contact (D3) in a length direction of the memory card, and is located outside the grounding contact 12b and the third data contact (D3).

In addition, the fourth data contact (D2) includes an extension portion, and the extension portion extends to an outside of the power supply contact (VCC).

FIG. 6 is a schematic structural diagram of a fourth embodiment of a memory card according to this application. The memory card 10 in this embodiment includes a packaging board 11 and a plurality of contacts (not shown) disposed on one side surface of the packaging board 11. In this embodiment, the plurality of contacts include nine contacts.

Eight contacts are distributed in a matrix with four rows and two columns. Contacts in the first column of the matrix are sequentially a first data contact, the command contact, the grounding contact, and a third data contact, and respectively correspond to a D1 pin, a CMD pin, a GND pin, and a D3 pin in the eMMC protocol. Contacts in the second column of the matrix are sequentially the clock contact, a second data contact, the power supply contact, and a fourth data contact, and respectively correspond to a CLK pin, a D0 pin, a VCC pin, and a D2 pin in the eMMC protocol.

In addition, a ninth contact is a second detection contact 12d. The power supply contact 12a disposed adjacent to the second detection contact 12d is disposed at an interval from the fourth data contact (D2) in a width direction of the memory card. The second detection contact 12d is disposed at an interval from the power supply contact 12a disposed adjacent to the second detection contact 12d and the fourth data contact (D2) in a length direction of the memory card, and is located outside the power supply contact 12a and the fourth data contact (D2).

In addition, the third data contact (D3) includes an extension portion, and the extension portion extends to an outside of the grounding contact 12b.

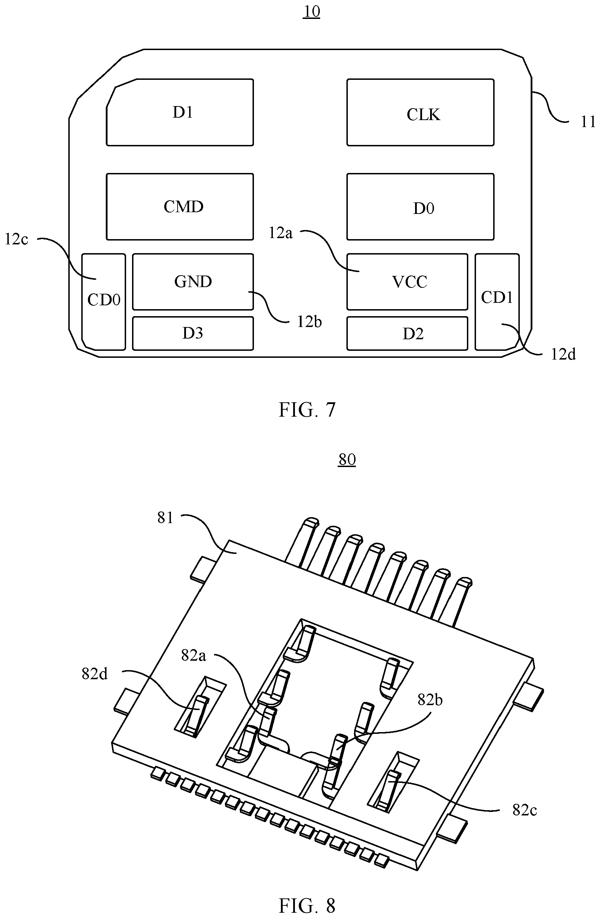

FIG. 7 is a schematic structural diagram of a fifth embodiment of a memory card according to this application. The memory card 10 in this embodiment includes a packaging board 11 and a plurality of contacts (not shown) disposed on one side surface of the packaging board 11. In this embodiment, the plurality of contacts include a total of 10 contacts.

Eight contacts are distributed in a matrix with four rows and two columns. Contacts in the first column of the matrix are sequentially a first data contact, the command contact, the grounding contact, and a third data contact, and respectively correspond to a D1 pin, a CMD pin, a GND pin, and a D3 pin in the eMMC protocol. Contacts in the second column of the matrix are sequentially the clock contact, a second data contact, the power supply contact, and a fourth data contact, and respectively correspond to a CLK pin, a D0 pin, a VCC pin, and a D2 pin in the eMMC protocol.

In addition, a ninth contact is a first detection contact 12c. The grounding contact 12b disposed adjacent to the first detection contact 12c is disposed at an interval from the third data contact (D3) in a width direction of the memory card. The first detection contact 12c is disposed at an interval from the grounding contact 12b disposed adjacent to the first detection contact 12c and the third data contact (D3) in a length direction of the memory card, and is located outside the grounding contact 12b and the third data contact (D3).

In addition, a tenth contact is a second detection contact 12d. The power supply contact 12a disposed adjacent to the second detection contact 12d is disposed at an interval from the fourth data contact (D2) in a width direction of the memory card. The second detection contact 12d is disposed at an interval from the power supply contact 12a disposed adjacent to the second detection contact 12d and the fourth data contact (D2) in a length direction of the memory card, and is located outside the power supply contact 12a and the fourth data contact (D2).

In addition, only one of the first detection contact 12c and the second detection contact 12d may be used for detection, and the other may be used as another function, for example, may be used as a data contact, a command contact, or a reset contact.

In addition, in the foregoing embodiment, the pins that are in an MMC protocol and that correspond to the contacts of the NM card are described. It may be understood that the foregoing embodiment is not only applicable to the MMC protocol, but may also correspond to an SD protocol, a UFS protocol, a USB protocol, and the like.

A comparison is made between FIG. 3 and FIG. 5 to FIG. 7. In the embodiments, an outline dimension of the packaging board of the NM card matches an outline dimension of the SIM card, so that a same connector can be shared with the SIM card.

Specifically, a length, a width, and a thickness of the packaging board are respectively 12.3 mm, 8.8 mm, and 0.7 mm, and one corner of the packaging board is provided with a bevel.

Optionally, in an embodiment, the bevel is of 45 degrees, and a width of the bevel is 1.65 mm.

It may be understood that in another embodiment, another corner of the packaging plate or a corner of each contact may be disposed beveled or rounded based on a requirement. This is not limited here.

With reference to FIG. 3 and FIG. 5, when the NM card and the SIM overlap, the first detection contact 12c of the NM card and the grounding contact 12b disposed adjacent to the first detection contact 12c are at least partially located in a projection area of the grounding contact (GND) corresponding to the SIM card.

With reference to FIG. 3 and FIG. 6, when the NM card and the SIM overlap, the second detection contact 12d of the NM card and the power supply contact 12a disposed adjacent to the second detection contact 12d are at least partially located in a projection area of the power supply contact (GND) corresponding to the SIM card.

With reference to FIG. 3 and FIG. 7, when the NM card and the SIM overlap, the first detection contact 12c of the NM card and the grounding contact 12b disposed adjacent to the first detection contact 12c are at least partially located in a projection area of the grounding contact (GND) corresponding to the SIM card, and the second detection contact 12d of the NM card and the power supply contact 12a disposed adjacent to the second detection contact 12d are at least partially located in a projection area of the power supply contact (GND) corresponding to the SIM card.

In the foregoing disposal, when two contact terminals are used to be in contact with the NM card, the two contact terminals are respectively in contact with the detection contact and the power supply contact/grounding contact, and when the same two contact terminals are used to be in contact with the SIM card, both the two contact terminals are in contact with the power supply contact or the grounding contact for subsequent card identification.

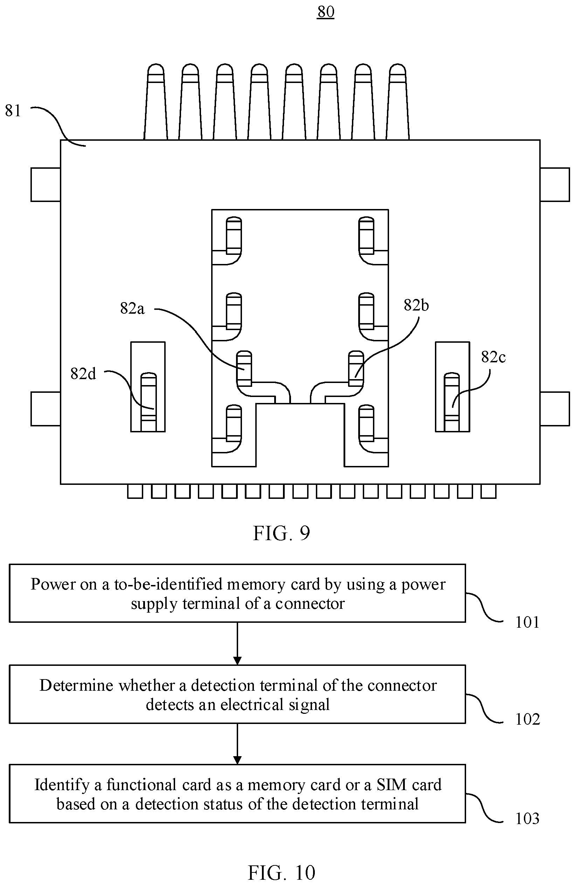

FIG. 8 is a schematic diagram of a three-dimensional structure of an embodiment of a connector according to this application, and FIG. 9 is a schematic structural diagram of a front view of an embodiment of a connector according to this application.

The connector 80 includes a plurality of contact terminals (not shown). The plurality of contact terminals include a power supply terminal 82a, a grounding terminal 82b, and a detection terminal (82c and/or 82d). When the memory card 10 shown in FIG. 1, FIG. 2, FIG. 5, FIG. 6, or FIG. 7 is in contact with the connector 80 through fitting, the detection terminal and the power supply terminal or the grounding terminal are respectively in contact with a detection contact on the memory card and a power supply contact or a grounding contact disposed adjacent to the detection contact.

Optionally, in an embodiment, the detection terminal specifically includes a first detection terminal 82c and a second detection terminal 82d.

Specifically, FIG. 3 is used as an example. When the SIM card is in contact with the connector 80 through fitting, a power supply contact VCC of the SIM card is in contact with both the power supply terminal 82a and the second detection terminal 82d, and a grounding contact GND of the SIM card is in contact with both the grounding terminal 82b and the first detection terminal 82c.

Specifically, FIG. 5 is used as an example. When the NM card is in contact with the connector 80 through fitting, the power supply contact 12a is in contact with the power supply terminal 82a, the grounding contact 12b is in contact with the grounding terminal 82b, and the first detection contact 12c is in contact with the first detection terminal 82c.

Specifically, FIG. 6 is used as an example. When the NM card is in contact with the connector 80 through fitting, the power supply contact 12a is in contact with the power supply terminal 82a, the grounding contact 12b is in contact with the grounding terminal 82b, and the second detection contact 12d is in contact with the second detection terminal 82d.

Specifically, FIG. 7 is used as an example. When the NM card is in contact with the connector 80 through fitting, the power supply contact 12a is in contact with the power supply terminal 82a, the grounding contact 12b is in contact with the grounding terminal 82b, the first detection contact 12c is in contact with the first detection terminal 82c, and the second detection contact 12d is in contact with the second detection terminal 82d.

Therefore, when the connector 80 is used to identify the memory card provided in this embodiment, it may be detected whether potentials of the power supply terminal 82a and the second detection terminal 82d are the same. If the potentials of the power supply terminal 82a and the second detection terminal 82d are the same, a to-be-identified card is identified as a SIM card. If the potentials of the power supply terminal 82a and the second detection terminal 82d are different, the to-be-identified card is identified as the memory card in this embodiment. Alternatively, it may be detected whether potentials of the grounding terminal 82b and the first detection terminal 82c are the same. If the potentials of the grounding terminal 82b and the first detection terminal 82c are the same, a to-be-identified card is identified as a SIM card. If the potentials of the grounding terminal 82b and the first detection terminal 82c are different, the to-be-identified card is identified as a memory card in this embodiment.

Optionally, there are a plurality of detection terminals, and the plurality of detection terminals correspond to detection contact settings of a plurality of different types of functional cards, to identify different types of functional cards based on detection statuses of different detection terminals.

For example, the connector may include two detection terminals, and the two detection terminals may be disposed corresponding to detection contacts of two different types of memory cards. Specifically, a first detection terminal corresponds to a first-type memory card, and a second detection terminal corresponds to a second-type memory card. When the memory card is identified, if the first detection terminal detects a specified electrical signal, the memory card is identified as the first-type memory card. If the second detection terminal detects a specified electrical signal, the memory card is identified as the second-type memory card.

In addition, with reference to the NM card in FIG. 4 and the NM card provided in FIG. 5-7, this embodiment further has the following advantages:

1. In FIG. 4, pins D2 and D3 are data I/Os, and cannot be used to identify hardware status. The six pins (namely, D1, CMD, GND, CLK, D0, and VCC) shared between the NM card and the SIM card are similar in function, and cannot be used to identify the hardware status. A new test pin is added to the NM card provided in this embodiment, to resolve a problem that the pins D2 and D3 cannot be used for identification.

2. Software identification performed by using an inventive command to obtain card response is unreliable, and communication is easily performed without good contact, resulting in system failure. In addition, an operating voltage of the NM card is 1.8 V or 3.3 V, and an operating voltage of the SIM card is 1.8 V or 3 V. In a software identification process, there is voltage switching. If an identification error occurs, an incorrect voltage is easily used to perform an operation on the memory card or the SIM card, and there is a potential risk.

3. The pins D2 and D3 in FIG. 4 are excessively long, which increases a risk of short-circuit to the VCC and the GND. However, this problem is resolved by changing the pins in this embodiment.

FIG. 10 is a schematic flowchart of a first embodiment of a functional card identification method according to this application. The method includes the following steps.

Step 101: Power on a to-be-identified memory card by using a power supply terminal of a connector.

It may be understood that a terminal of the connector is relatively fixed, and therefore the to-be-identified memory card can be powered on only after a matching functional card is inserted. For example, the connector in this embodiment is applicable to an NM card, a SIM card, and another card with a similar contact layout.

Specifically, the power supply terminal of the connector is in contact with a power supply contact of the functional card, and a grounding terminal of the connector is in contact with a grounding contact of the functional card.

Step 102: Determine whether a detection terminal of the connector detects an electrical signal.

Step 103: Identify the functional card as a memory card or a SIM card based on a detection status of the detection terminal.

It may be understood that based on the structures of the NM card, the SIM card, and the connector provided in the foregoing embodiments, the detection terminal corresponds to a detection contact of the NM card and a power supply contact or a grounding contact of the SIM. Therefore, identification may be performed based on differences between electrical signals of the detection contact and each of the power supply contact and the grounding contact.

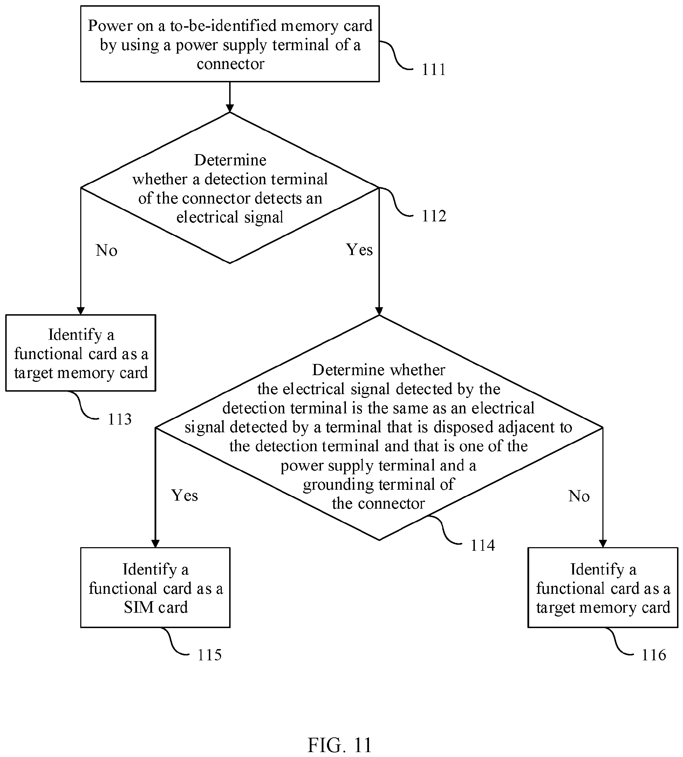

FIG. 11 is a schematic flowchart of a second embodiment of a functional card identification method according to this application. The method includes the following steps.

Step 111: Power on a to-be-identified memory card by using a power supply terminal of a connector.

Step 112: Determine whether a detection terminal of the connector detects an electrical signal.

If no electrical signal is detected, step 113 is performed. If an electrical signal is detected, step 114 is performed.

Step 113: Identify the functional card as a target memory card.

Step 114: Determine whether the electrical signal detected by the detection terminal is the same as an electrical signal detected by a terminal that is disposed adjacent to the detection terminal and that is one of the power supply terminal and the grounding terminal of the connector.

If the electrical signal detected by the detection terminal is the same as the electrical signal detected by the terminal that is disposed adjacent to the detection terminal and that is one of the power supply terminal and the grounding terminal of the connector, step 115 is performed. If the electrical signal detected by the detection terminal is different from the electrical signal detected by the terminal that is disposed adjacent to the detection terminal and that is one of the power supply terminal and the grounding terminal of the connector, step 116 is performed.

Step 115: Identify the functional card as a SIM card.

Step 116: Identify the functional card as a target memory card.

In an embodiment in which the detection contact corresponding to the detection terminal is not connected to the power supply contact or the grounding contact, the detection contact is equivalent to being suspended. In this case, the detection terminal detects no electrical signal.

In another embodiment, for the memory card, no contact may be disposed at a position corresponding to the detection terminal. In this case, the detection terminal cannot detect any electrical signal, and the functional card is also identified as a target memory card.

In addition, in an embodiment in which the detection contact is adjacent to the power supply contact, in case of a SIM card, potentials of the detection terminal and the power supply terminal should be the same. However, in the memory card, the detection contact is connected to the grounding contact, and therefore potentials of the detection terminal and the power supply terminal are opposite.

Similarly, in an embodiment in which the detection contact is adjacent to the grounding contact, in case of a SIM card, potentials of the detection terminal and the power supply terminal should be the same. However, in the memory card, the detection contact is connected to the power supply contact, and therefore potentials of the detection terminal and the power supply terminal are opposite.

Therefore, the SIM card and the memory card can be identified by determining whether a potential of the detection contact is the same as that of the power supply contact, or whether a potential of the detection contact is the same as that of the grounding contact.

The foregoing descriptions are merely implementations of this application, and are not intended to limit the scope of this application. An equivalent structural or equivalent process alternation made by using the content of this specification and the drawings of this application, or an application of the content of this specification and drawings directly or indirectly to another related technical field shall fall within the protection scope of this application.

## Claims

1. A memory card, comprising:
a packaging board; and
a plurality of contacts disposed on one side surface of the packaging board, wherein the plurality of contacts comprise a power supply contact, a grounding contact, and a detection contact, and the detection contact is disposed adjacent to one of the power supply contact and the grounding contact, and is suspended or electrically connected to the other of the power supply contact and the grounding contact.

2. The memory card according to claim 1, wherein
the detection contact comprises a first detection contact and a second detection contact, wherein
the first detection contact is disposed adjacent to the grounding contact, and is suspended or electrically connected to the power supply contact, and the second detection contact is disposed adjacent to the power supply contact, and is suspended or electrically connected to the grounding contact.

3. The memory card according to claim 1, wherein
the plurality of contacts further comprise a functional contact; and
the detection contact is disposed adjacent to the power supply contact, and is suspended or electrically connected to the grounding contact, and the functional contact is disposed adjacent to the grounding contact; or
the detection contact is disposed adjacent to the grounding contact, and is suspended or electrically connected to the power supply contact, and the functional contact is disposed adjacent to the power supply contact.

4. The memory card according to claim 1, wherein
an outline dimension of the packaging board matches an outline dimension of a SIM card, to share a same connector with the SIM card; and
when the SIM card and the memory card overlap, the detection contact on the memory card and the power supply contact or the grounding contact disposed adjacent to the detection contact are at least partially located in a projection area of a power supply contact or a grounding contact corresponding to the SIM card.

5. The memory card according to claim 4, wherein
the plurality of contacts of the memory card further comprise a data contact that is at least partially located in the projection area.

6. The memory card according to claim 5, wherein
the power supply contact or the grounding contact disposed adjacent to the detection contact is disposed at an interval from the data contact in a width direction of the memory card, and the detection contact is disposed at an interval from the power supply contact or the grounding contact disposed adjacent to the detection contact and the data contact in a length direction of the memory card, and is located outside the data contact, and the power supply contact or the grounding contact disposed adjacent to the detection contact.

7. The memory card according to claim 4, wherein
the plurality of contacts of the memory card further comprise a data contact, a command contact, a clock contact, and a data contact.

8. The memory card according to claim 1, wherein
the plurality of contacts are distributed in a matrix with four rows and two columns.

9. A connector, wherein the connector comprises a plurality of contact terminals; and
the plurality of contact terminals comprise a power supply terminal, a grounding terminal, and a detection terminal, and when the memory according to any one of claims 1 to 8 is in contact with the connector through fitting, the detection terminal and the power supply terminal or the grounding terminal are respectively in contact with a detection contact on the memory card and a power supply contact or a grounding contact disposed adjacent to the detection contact.

10. The connector according to claim 9, wherein
the connector is further shared by a SIM card, and when the SIM card is in contact with the connector through fitting, both the detection terminal and the power supply terminal or the grounding terminal are in contact with a power supply contact or a grounding contact corresponding to the SIM card.

11. The connector according to claim 9, wherein
there are a plurality of detection terminals, and the plurality of detection terminals correspond to detection contact settings of a plurality of different types of functional cards, to identify different types of functional cards based on detection statuses of different detection terminals.

12. A functional card identification method, wherein the connector according to any one of claims 9 to 11 is used in the method, and the method comprises:
powering on a to-be-identified memory card by using a power supply terminal of the connector;
determining whether a detection terminal of the connector detects an electrical signal; and
identifying the functional card as a memory card or a SIM card based on a detection status of the detection terminal.

13. The method according to claim 12, wherein
the step of identifying the functional card as a memory card or a SIM card based on a detection status of the detection terminal comprises:
if the detection terminal detects no electrical signal, identifying the functional card as a target memory card; or
if the detection terminal detects an electrical signal, further determining whether the electrical signal detected by the detection terminal is the same as an electrical signal detected by a terminal that is disposed adjacent to the detection terminal and that is one of a power supply terminal and a grounding terminal of the connector; and
if the electrical signal detected by the detection terminal is the same as the electrical signal detected by the terminal that is disposed adjacent to the detection terminal and that is one of the power supply terminal and the grounding terminal of the connector, identifying the functional card as a SIM card; or
if the electrical signal detected by the detection terminal is different from the electrical signal detected by the terminal that is disposed adjacent to the detection terminal and that is one of the power supply terminal and the grounding terminal of the connector, identifying the functional card as a target memory card.
